# EUROPEAN PATENT SPECIFICATION

(11) **EP 4 016 613 B1**
(45) Date of publication and mention of the grant of the patent: **02.07.2025**
(21) Application number: 20856813.9
(22) Date of filing: 11.08.2020
(51) Int. Cl.: H01L 23/00, H05K 3/34

(54) **ELECTRONIC ASSEMBLY, AND ELECTRONIC APPARATUS**
ELEKTRONISCHE ANORDNUNG UND ELEKTRONISCHE VORRICHTUNG
ENSEMBLE ÉLECTRONIQUE ET APPAREIL ÉLECTRONIQUE

(30) Priority: 30.08.2019 CN 201910817423
(43) Date of publication of application: 22.06.2022
(73) Proprietor: Huawei Technologies Co., Ltd., Longgang District Shenzhen, Guangdong 518129 (CN)
(72) Inventor: ZHOU, Yang, Shenzhen, Guangdong 518129 (CN); LONG, Haohui, Shenzhen, Guangdong 518129 (CN); YE, Runqing, Shenzhen, Guangdong 518129 (CN); FANG, Jianping, Shenzhen, Guangdong 518129 (CN); WANG, Zhuqiu, Shenzhen, Guangdong 518129 (CN)
(74) Representative: Epping - Hermann - Fischer
(86) International application number: PCT/CN2020/108530
(87) International publication number: WO 2021/036786

(56) References cited:
- WO-A1-94/17551
- CN-A- 1 491 433
- CN-A- 1 574 305
- CN-A- 104 716 058
- US-A- 5 872 400
- US-A- 5 956 606
- US-A1- 2010 105 173
- US-A1- 2014 285 989

## Description

### TECHNICAL FIELD

This application relates to the field of electronic technologies, and in particular, to an electronic assembly and an electronic device.

### BACKGROUND

With development of electronic technologies, an electronic device is continuously developing toward miniaturization, integration, and ultra-thinness. Therefore, an increasingly high requirement is posed to a bonding process for electronic components in the electronic device. A bonding effect between the electronic components in the electronic device is crucial to performance of the electronic device.

When two electronic components are bonded, if a high-temperature solder with a high melting temperature is used for bonding, the electronic components are warped, or performance of the electronic components is changed. As a result, reliability of the electronic components is affected. However, if a low-temperature solder with a low bonding temperature is used for bonding, because the low-temperature solder has high brittleness and a low elongation rate, the low-temperature solder and solder pads on the electronic components form an intermetallic compound (intermetallic compound, IMC) with low strength. As a result, reliability of the bonding between the electronic components is low.

Therefore, how to improve stability of bonding between electronic components without affecting performance of the electronic components becomes an urgent technical issue to be addressed by persons skilled in the art.

US 2010/105173 A1 discloses a method for manufacturing a semiconductor device by mounting a semiconductor element on a circuit board, the semiconductor element having a first electrode made of a first material on a semiconductor substrate, the circuit board having a second electrode made of a second material on an insulating substrate. The method includes forming a connecting member on the first electrode, a melting point of the connecting member being lower than a melting point of the first material, placing the semiconductor element on the circuit board, so as to face the connecting member toward the second electrode, and connecting the first electrode and the second electrode, so as to interpose the connecting member between the first electrode and the second electrode, at a temperature that is lower than the melting point of the first material and higher than the melting point of the connecting member.

US 5956606 A discloses an electrical interconnect structure, including a first component, a second component, and an electrical interconnect electrically and mechanically interconnecting the first component to the second component, the electrical interconnect including a first solder sphere and a second solder sphere stacked on each other.

US 2014/285989 A1 discloses a method of mounting a semiconductor element, the method includes: attaching a first solder joint material onto a first pad formed on a substrate supplying a second solder joint material onto the first solder joint material, a second melting point of the second solder joint material being lower than a first melting point of the first solder joint material; arranging the semiconductor element so that a second pad formed on the semiconductor element faces the first pad and a joint gap is provided between the semiconductor element and the substrate; and performing reflow at a reflow temperature lower than the first melting point and higher than the second melting point to join the first solder joint material and the second solder joint material.

### SUMMARY

The invention is defined in the claims. In the following, parts of the description and drawings referring to embodiments which are not covered by the claims are not presented as embodiments of the invention, but as examples useful for understanding the invention.

Embodiments of this application provide an electronic assembly and an electronic device, to resolve low stability of bonding between electronic components.

To achieve the foregoing objective, the following technical solutions are used in the embodiments. According to a first aspect, an electronic assembly is provided, including: a first electronic component, where a first active surface of the first electronic component has at least one first solder pad; a second electronic component, where a second active surface of the second electronic component has at least one second solder pad, and the second active surface faces the first active surface; and at least one first soldering portion, where one first soldering portion is located between one first solder pad and one second solder pad, and the first soldering portion is bonded to the first solder pad and the second solder pad on both sides of the first soldering portion. The first soldering portion includes a high-temperature solder layer and a low-temperature solder layer. The high-temperature solder layer is disposed close to the first solder pad and is bonded to the first solder pad. The low-temperature solder layer is disposed close to the second solder pad and is bonded to the second solder pad. A melting point of the low-temperature solder layer is lower than that of the high-temperature solder layer, and a material constituting the low-temperature solder layer is partially the same as that constituting the high-temperature solder layer, so that the low-temperature solder layer is bonded to the high-temperature solder layer through atomic diffusion. In the electronic assembly provided in this embodiment of this application, the high-temperature solder layer is bonded to the first solder pad, and an IMC with high strength is formed on a bonding interface. In addition, the low-temperature solder layer is bonded to the high-temperature solder layer through atomic diffusion, and no IMC is formed in a bonding process. Stability of bonding between the first electronic component and the first soldering portion can be improved, thereby improving stability of the electronic assembly.

The electronic assembly further includes at least one second soldering portion. The second soldering portion is disposed on a side that is of the first soldering portion and close to the second solder pad, and is bonded to the second solder pad. The melting point of the low-temperature solder layer is lower than that of the second soldering portion, and the material constituting the low-temperature solder layer is partially the same as that constituting the second soldering portion, so that the low-temperature solder layer is bonded to the second soldering portion through atomic diffusion. In the electronic assembly provided in this embodiment of this application, the second soldering portion is bonded to the second solder pad, and an IMC with high strength is formed on a bonding interface. In addition, the low-temperature solder layer is bonded to the second soldering portion through atomic diffusion, and no IMC is formed in a bonding process. Stability of bonding between the second electronic component and the second soldering portion can be improved, thereby improving stability of the electronic assembly.

Optionally, a bonding interface between the high-temperature solder layer and the low-temperature solder layer is a plane, and the material constituting the high-temperature solder layer is a pure metal. The high-temperature solder layer may be formed by using an electroplating process, and the process is simple.

Optionally, a bonding interface between the high-temperature solder layer and the low-temperature solder layer is a curved surface whose center is concave toward a side on which the first solder pad is located, and the material constituting the high-temperature solder layer is a metal alloy. A requirement for the material of the high-temperature solder layer is low, and a high-temperature solder commonly used on the market may be used.

Optionally, an orthographic projection of the first solder pad on the first electronic component falls within an orthographic projection of the second solder pad on the first electronic component. In this structure, the first solder pad and the second solder pad directly face each other with a large area, and a good bonding effect.

Optionally, the low-temperature solder layer has a thickness of 50-100 µm in a direction perpendicular to the first solder pad. When the low-temperature solder layer is excessively thin, a bonding effect between the low-temperature solder layer and each of the high-temperature solder layer and the second soldering portion is affected. However, when the low-temperature solder layer is excessively thick, this is not conducive to preparation by brushing solder paste over a steel mesh. The high-temperature solder layer or the second soldering portion has a thickness of 10-100 µm in a direction perpendicular to the first solder pad. With drop simulation analysis on the electronic assembly, the first soldering portion and the second soldering portion are subject to large stress at a location within 10 µm away from the first solder pad and the second solder pad. However, when the first soldering portion and the second soldering portion are excessively thick, this is not conducive to preparation by brushing solder paste over a steel mesh.

Optionally, the second soldering portion is a micro protrusion disposed on the second solder pad. The electronic assembly provided in this embodiment of this application is also applicable to bonding of a BGA device.

Optionally, the electronic assembly further includes an underfill adhesive layer located between the first electronic component and the second electronic component. The underfill adhesive layer is separately bonded to the first active surface and the second active surface, surrounds peripheries of the first soldering portion and the second soldering portion, and is bonded to the first soldering portion and the second soldering portion. The underfill adhesive layer is filled between the first electronic component and the second electronic component, and the underfill adhesive layer is bonded to the first soldering portion and the second soldering portion, so that the first soldering portion and the second soldering portion can be protected and secured, to further improve stability of bonding between the first electronic component and the second electronic component. According to a second aspect, a method for preparing an electronic assembly is provided. The electronic assembly includes a first electronic component and a second electronic component. A first active surface of the first electronic component has at least one first solder pad. A second active surface of the second electronic component has at least one second solder pad. The second active surface faces the first active surface. The method for preparing an electronic assembly includes: forming, on each first solder pad of the first electronic component, a high-temperature solder layer bonded to the first solder pad; placing a low-temperature solder between the high-temperature solder layer and the second solder pad; and separately bonding the low-temperature solder to the high-temperature solder layer and the second solder pad through atomic diffusion, to form a low-temperature solder layer, where the bonded high-temperature solder layer and low-temperature solder layer serve as a first soldering portion to bond the first electronic component to the second electronic component. A melting point of the low-temperature solder layer is lower than that of the high-temperature solder layer, and a material constituting the low-temperature solder layer is partially the same as that constituting the high-temperature solder layer.

Optionally, the material constituting the high-temperature solder layer is a metal alloy, and the forming, on each first solder pad of the first electronic component, a high-temperature solder layer bonded to the first solder pad includes: placing, on each first solder pad of the first electronic component, a first high-temperature solder; and bonding the first high-temperature solder to the first solder pad, to form the high-temperature solder layer bonded to the first solder pad.

Optionally, the material constituting the high-temperature solder layer is a pure metal, and the forming, on each first solder pad of the first electronic component, a high-temperature solder layer bonded to the first solder pad includes: forming, on the first solder pad of the first electronic component by using an electroplating process, the high-temperature solder layer bonded to the first solder pad Optionally, the placing a low-temperature solder between the high-temperature solder layer and the second solder pad includes: placing the low-temperature solder on the high-temperature solder layer.

Optionally, the placing a low-temperature solder between the high-temperature solder layer and the second solder pad includes: placing the low-temperature solder on the second solder pad.

Optionally, before the separately bonding the low-temperature solder to the high-temperature solder layer and the second solder pad through atomic diffusion, the method for preparing an electronic assembly further includes: attaching the first electronic component to the second electronic component in alignment, so that the low-temperature solder separately attached to the high-temperature solder layer and the second solder pad.

Before the separately bonding the low-temperature solder to the high-temperature solder layer and the second solder pad through atomic diffusion, the method for preparing an electronic assembly further includes: forming, on each second solder pad of the second electronic component, a second soldering portion bonded to the second solder pad, where the melting point of the low-temperature solder layer is lower than that of the second soldering portion, and the material constituting the low-temperature solder layer is partially the same as that constituting the second soldering portion. The bonding the low-temperature solder to the second solder pad through atomic diffusion includes: bonding the low-temperature solder to the second soldering portion through atomic diffusion.

Optionally, the material constituting the second soldering portion is a metal alloy, and the forming, on each second solder pad of the second electronic component, a second soldering portion bonded to the second solder pad includes: placing, on each second solder pad of the second electronic component, a second high-temperature solder; and bonding the second high-temperature solder to the second solder pad, to form the second soldering portion bonded to the second solder pad.

Optionally, the material constituting the second soldering portion is a pure metal, and the forming, on each second solder pad of the second electronic component, a second soldering portion bonded to the second solder pad includes: forming, on the second solder pad of the second electronic component by using an electroplating process, the second soldering portion bonded to the second solder pad.

Optionally, the placing a low-temperature solder between the high-temperature solder layer and the second solder pad includes: placing the low-temperature solder on the second soldering portion. Optionally, before the bonding the low-temperature solder to the second soldering portion through atomic diffusion, the method for preparing an electronic assembly further includes: attaching the first electronic component to the second electronic component in alignment, so that the low-temperature solder separately attached to the high-temperature solder layer and the second soldering portion.

According to a third aspect, an electronic device is provided, including the electronic assembly according to any one of the implementations of the first aspect.

### BRIEF DESCRIPTION OF DRAWINGS

FIG. 1 is a schematic diagram of a structure of an electronic device according to an embodiment of this application;
FIG. 2a is a schematic diagram of a structure of an electronic assembly according to an embodiment of this application;
FIG. 2b is a schematic diagram of a structure of another electronic assembly according to an embodiment of this application;
FIG. 3a is a schematic sectional view along an A-A' direction in FIG. 2a according to an embodiment of this application not forming part of the invention;
FIG. 3b is a schematic diagram of a bonded structure of a first electronic component and a second electronic component in a related technology;
FIG. 4 is a diagram of force-bearing distribution of a first soldering portion of an electronic assembly according to an embodiment of this application not forming part of the invention;
FIG. 5 is another schematic sectional view along an A-A' direction in FIG. 2a according to an embodiment of this application forming part of the invention;
FIG. 6a to FIG. 6g are schematic diagrams of a size relationship between a first solder pad and a second solder pad according to an embodiment of this application;
FIG. 7a to FIG. 7f are schematic diagrams of shapes of a first solder pad according to an embodiment of this application;
FIG. 8a is a flowchart of a bonding process of a first electronic component and a second electronic component according to an embodiment of this application;
FIG. 8b is a flowchart of another bonding process of a first electronic component and a second electronic component according to an embodiment of this application;
FIG. 9a to FIG. 9h are schematic diagrams of a bonding process of an electronic assembly according to an embodiment of this application forming part of the invention;
FIG. 10a to FIG. 10c are schematic diagrams of a bonding interface between a high-temperature solder layer and a low-temperature solder layer according to an embodiment of this application forming part of the invention;
FIG. 11a to FIG. 11d are schematic diagrams of a side surface of a low-temperature solder layer according to an embodiment of this application forming part of the invention;
FIG. 12 is a flowchart of another bonding process of an electronic assembly according to an embodiment of this application forming part of the invention;
FIG. 13a to FIG. 13d are schematic diagrams of another bonding process of an electronic assembly according to an embodiment of this application forming part of the invention;
FIG. 14 is a diagram of force-bearing distribution of a first soldering portion and a second soldering portion of an electronic assembly according to an embodiment of this application forming part of the invention;
FIG. 15 is still another schematic sectional view along an A-A' direction in FIG. 2a according to an embodiment of this application forming part of the invention;
FIG. 16 is still another schematic sectional view along an A-A' direction in FIG. 2a according to an embodiment of this application forming part of the invention;
FIG. 17a is a flowchart of still another bonding process of an electronic assembly according to an embodiment of this application forming part of the invention;
FIG. 17b and FIG. 17c are schematic diagrams of still another bonding process of an electronic assembly according to an embodiment of this application forming part of the invention;
FIG. 18 is still another schematic sectional view along an A-A' direction in FIG. 2a according to an embodiment of this application forming part of the invention; and
FIG. 19 is still another schematic sectional view along an A-A' direction in FIG. 2a according to an embodiment of this application forming part of the invention.

### Reference numerals:

1: electronic device; 2: display module; 3: middle frame; 4: housing; 5: cover plate; 100: electronic assembly; 10: first electronic component; 11: first solder pad; 20: second electronic component; 21: second solder pad; 30: first soldering portion; 31: high-temperature solder layer; 32: low-temperature solder layer; 40: second soldering portion; G1: first high-temperature solder; G2: second high-temperature solder; D: low-temperature solder; 50: steel mesh; 51: opening; 52: shielding portion; and 60: underfill adhesive layer.

### DESCRIPTION OF EMBODIMENTS

Technical terms or scientific terms used in this application should have general meanings understood by persons skilled in the art, unless otherwise defined. Terms "first", "second", and "third", and similar expressions used in the specification and claims of this application do not indicate any order, quantity, or importance, but are merely intended to distinguish between different components. Therefore, a feature limited by "first", "second", or "third" may explicitly or implicitly include one or more features. In the descriptions of the embodiments of this application, "a plurality of" means at least two, unless otherwise specified.

Orientation terms such as "left", "right", "up", and "down" are defined with respect to placement orientations of components shown in the accompanying drawings. It should be understood that these directional terms are relative concepts and are used for relative descriptions and clarifications, and may vary accordingly based on changes of the placement orientations of the components.

An embodiment of this application provides an electronic device. The electronic device may be a terminal device with a display interface, for example, a mobile phone, a television, a display, a tablet computer, or a vehicle-mounted computer, may be an intelligent wearable display device, for example, a smart watch or a smart band, or may be a communications device, for example, a server, a memory, or a base station; or is a smart car or the like. A specific form of the electronic device is not particularly limited in this embodiment of this application. For ease of description, the following embodiments are described by using an example in which the electronic device is a mobile phone.

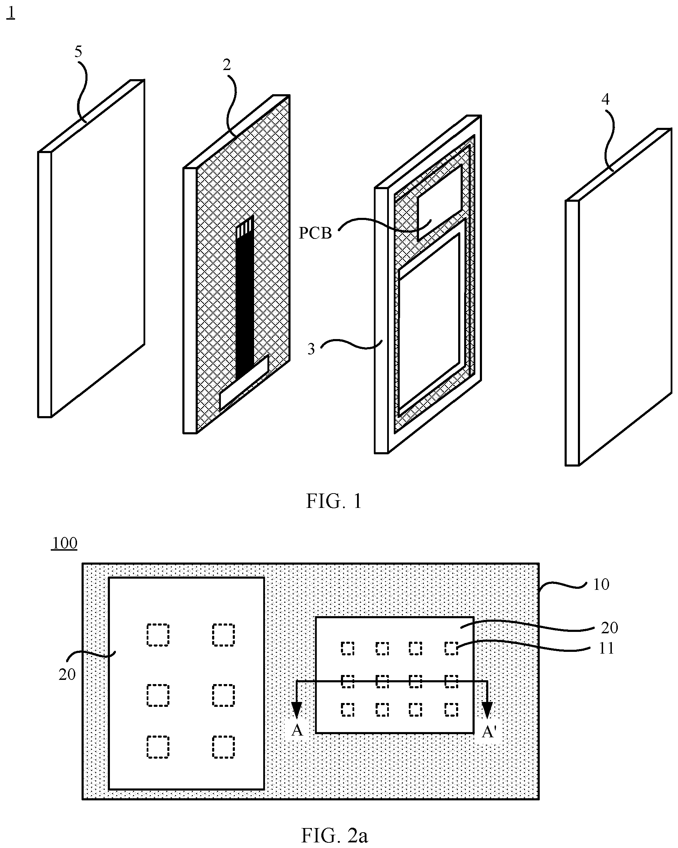

In this case, as shown in FIG. 1, the electronic device 1 mainly includes a display module 2, a middle frame 3, a housing (or referred to as a battery cover or a rear housing) 4, and a cover plate 5.

The display module 2 has a light exit side on which a displayed image can be seen, and a rear surface opposite to the light exit side. The back surface of the display module 2 is close to the middle frame 3. The cover plate 5 is disposed on the light exit side of the display module 2.

The display module 2 includes a display panel (display panel, DP).

In a possible embodiment of this application, the display module 2 is a liquid crystal display module. In this case, the display panel is a liquid crystal display (liquid crystal display, LCD). In view of this, the display module 2 further includes a backlight unit (back light unit, BLU) located on a rear surface (away from a surface, of the LCD, that is used to display an image) of the liquid crystal display.

The backlight unit may provide a light source for the liquid crystal display, so that each sub-pixel (sub pixel) in the liquid crystal display can emit light to display an image.

Alternatively, in another possible embodiment of this application, the display module 2 is an organic light emitting diode display module. In this case, the display panel is an organic light emitting diode (organic light emitting diode, OLED) display panel. Because an electroluminescent layer is disposed in each sub-pixel of the OLED display panel, the OLED display panel can implement self-illumination after receiving a working voltage. In this case, the backlight unit no longer needs to be disposed in the display module 2 with the OLED display panel.

The cover plate 5 is located on a side, of the display module 2, that is away from the middle frame 3. For example, the cover plate 5 may be cover glass (cover glass, CG), and the cover glass may have specific flexibility.

The middle frame 3 is located between the display module 2 and the housing 4. A surface, of the middle frame 3, that is away from the display module 2 is used to mount internal components, for example, a battery, a printed circuit board (printed circuit board, PCB), a camera (camera), and an antenna. After the housing 4 and the middle frame 3 are closed, the internal components are located between the housing 4 and the middle frame 3.

The electronic device 1 further includes a main board disposed on the PCB. The PCB is configured to carry the main board and is bonded to the main board, so that the main board can control each component in the electronic device 1. For example, the main board may be a central processing unit (central processing unit, CPU). Stability of bonding between the main board and the PCB plays a critical role in performance of the electronic device 1. For example, breaking at a bonding location between the main board and the PCB causes signal interruption between the main board and the PCB, thereby causing damage to the electronic device 1.

Certainly, a plurality of electronic components are bonded in the electronic device 1. For example, a fingerprint module used for fingerprint recognition is bonded to a flexible printed circuit (flexible printed circuit, FPC) board, and the FPC is bonded to the PCB, to implement a fingerprint recognition function of the electronic device 1. Alternatively, for example, chips with a plurality of functions in a system on chip (system on chip, SOC) are bonded to complete a system-in-a-package (system in a package, SIP). Alternatively, for example, the SOC is bonded to the PCB, a power module is bonded to the PCB, and a packaging device is bonded to the PCB.

Electronic components may be classified into a land grid array (land grid array, LGA) device and a ball grid array (ball grid array, BGA) device based on different structures, in the electronic components, that are used for bonding to other devices. The LGA device is bonded to another device by using a solder pad. The BGA device is bonded to another device by using a solder ball.

In view of this, to improve stability of bonding between electronic components in the electronic device 1, to ensure performance of the electronic device 1, as shown in FIG. 2a, an embodiment of this application provides an electronic assembly 100, including: a first electronic component 10 and a second electronic component 20.

Herein, the first electronic component 10 and the second electronic component 20 may be any component with an electrical signal transmission function in the electronic device 1, for example, a connector, an electronic transformer, a relay, a laser device, a PCB, an FPC, an integrated circuit (or referred to as a chip), a packaging device, a biometric authentication module, a processor, a memory, or a power module.

In a possible embodiment, as shown in FIG. 2a, for example, the first electronic component 10 is a PCB, and the second electronic component 20 is a processor. In this case, because the PCB has a large area, the first electronic component 10 may be bonded to another second electronic component 20 in addition to the processor. Certainly, first solder pads 11 bonded to different second electronic components 20 may have different shapes and sizes. The processor may be an LGA device, that is, is bonded to the PCB by using a solder pad. Alternatively, the processor may be a BGA device, that is, is bonded to the PCB by using a solder ball.

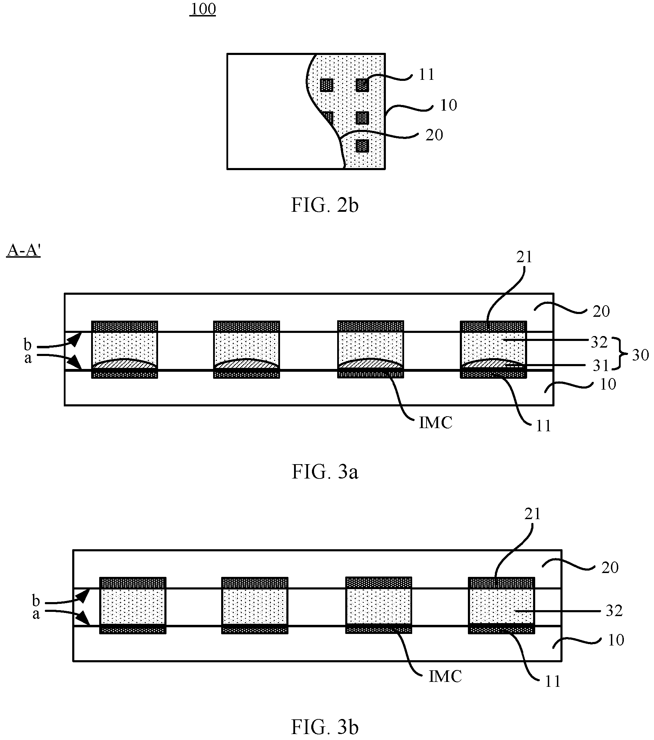

In another possible embodiment, as shown in FIG. 2b, for example, both the first electronic component 10 and the second electronic component 20 are dies (die). In this case, the first electronic component 10 and the second electronic component 20 are equal in size. Therefore, the first electronic component 10 and the second electronic component 20 are bonded in a one-to-one correspondence.

As shown in FIG. 3a (a sectional view along an A-A' direction in FIG. 2a), representing an embodiment not forming part of the invention, a first active surface a of the first electronic component 10 has at least one first solder pad 11. In FIG. 3a, an example in which the first active surface a of the first electronic component 10 has a plurality of first solder pads 11 is used for description.

An active surface of an electronic component is a surface, of the electronic component, on which a solder pad is disposed and the electronic component is electrically connected to another device by using the solder pad to implement signal interaction.

A second active surface b of the second electronic component 20 has at least one second solder pad 21. The second active surface b of the second electronic component 20 faces the first active surface a of the first electronic component 10.

For example, a material of the first solder pad 11 and the second solder pad 21 is a pure metal, for example, copper (Cu).

As shown in FIG. 3a, the electronic assembly 100 further includes at least one first soldering portion 30. One first soldering portion 30 is located between one first solder pad 11 and one second solder pad 21, and the first soldering portion 30 is bonded (bonding) to the first solder pad 11 and the second solder pad 21 located on both sides of the first soldering portion 30.

Bonding is a process in which two homogeneous or heterogeneous materials undergo surface processing and are directly combined under a specific condition to implement electrical or mechanical interconnection between the two materials. In this embodiment of this application, for example, a bonding effect may be achieved by using a soldering process. A quantity of the first soldering portions 30 is related to a quantity of the first solder pads 11 and the second solder pads 21. Each group of the first solder pad 11 and the second solder pad 21 that face each other are bonded by using one first bonding portion 30.

As shown in FIG. 3a, the first soldering portion 30 includes a high-temperature solder layer 31 and a low-temperature solder layer 32. The high-temperature solder layer 31 is disposed close to the first solder pad 11, and the high-temperature solder layer 31 is bonded to the first solder pad 11. The low-temperature solder layer 32 is disposed close to the second solder pad 21, and the low-temperature solder layer 32 is bonded to the second solder pad 21.

For a bonding process of the low-temperature solder layer 32 and the second solder pad 21, in a possible embodiment, the high-temperature solder layer 31 bonded to the first solder pad 11 is formed on the first solder pad 11, and then a low-temperature solder is placed on the high-temperature solder layer 31. Then the first electronic component 10 is attached to the second electronic component 20 in alignment, so that the low-temperature solder is located between the high-temperature solder layer 31 and the second solder pad 21. Finally, the low-temperature solder is separately bonded to the high-temperature solder layer 31 and the second solder pad 21 through atomic diffusion, to form the low-temperature solder layer 32 separately bonded to the second solder pad 21 and the high-temperature solder layer 31. The bonded high-temperature solder layer 31 and low-temperature solder layer 32 serve as the first soldering portion 30 to bond the first electronic component 10 to the second electronic component 20.

For a bonding process of the low-temperature solder layer 32 and the second solder pad 21, in another possible embodiment, the high-temperature solder layer 31 bonded to the first solder pad 11 is formed on the first solder pad 11, and then a low-temperature solder is placed on the second solder pad 21. Then the first electronic component 10 is attached to the second electronic component 20 in alignment, so that the low-temperature solder is located between the high-temperature solder layer 31 and the second solder pad 21. Finally, the low-temperature solder is separately bonded to the high-temperature solder layer 31 and the second solder pad 21 through atomic diffusion, to form the low-temperature solder layer 32 separately bonded to the second solder pad 21 and the high-temperature solder layer 31. The bonded high-temperature solder layer 31 and low-temperature solder layer 32 serve as the first soldering portion 30 to bond the first electronic component 10 to the second electronic component 20. A difference from the bonding process of the low-temperature solder layer 32 and the second solder pad 21 in the foregoing embodiment lies in that the low-temperature solder is placed on the second solder pad 21.

The low-temperature solder layer 32 may be bonded to the second solder pad 21 through direct contact or by using another component.

A melting point of the low-temperature solder layer 32 is lower than that of the high-temperature solder layer 31, and a material constituting the low-temperature solder layer 32 is partially the same as that constituting the high-temperature solder layer 31, so that the low-temperature solder layer 32 is bonded to the high-temperature solder layer 31 through atomic diffusion.

In this embodiment of this application, the melting point of the low-temperature solder layer 32 is lower than that of the high-temperature solder layer 31, but a range of the melting point of the low-temperature solder layer 32 is not limited. During selection of the material of the low-temperature solder layer 32, the melting point of the low-temperature solder layer 32 should be as low as possible while it is ensured that bonding reliability meets a requirement.

The material of the high-temperature solder layer 31 may be a metal alloy, or the material of the high-temperature solder layer 31 may be a pure metal.

The material constituting the low-temperature solder layer 32 being partially the same as that constituting the high-temperature solder layer 31 may be understood as that, when the material of the high-temperature solder layer 31 is a metal alloy, the material constituting the low-temperature solder layer 32 and the material constituting the high-temperature solder layer 31 include a same main material but different dopant materials.

For example, in a possible embodiment, the material of the high-temperature solder layer 31 is a tin alloy. The material of the high-temperature solder layer 31 is obtained by doping metals such as silver (Ag), antimony (Sb), and lead (Pb) in a main material tin (Sn). The material of the low-temperature solder layer 32 is obtained by doping metals such as bismuth (Bi), indium (In), and cadmium (Cd) in the main material tin. The material of the high-temperature solder layer 31 and the material of the low-temperature solder layer 32 include the same main material but different dopant materials.

The material constituting the low-temperature solder layer 32 being partially the same as that constituting the high-temperature solder layer 31 may also be understood as that, when the material of the high-temperature solder layer 31 is a pure metal, a main material in the material of the low-temperature solder layer 32 is the pure metal constituting the high-temperature material layer 31, and another metal material is further doped in the main material.

For example, in another possible embodiment, the material of the high-temperature solder layer 31 is a silver element, and the material of the low-temperature solder layer 32 is obtained by doping copper, tin, nickel (Ni), zinc (Zn), or boron (B) in a main material silver (for example, BAg40CuZnSnNi).

In this way, because the material constituting the low-temperature solder layer 32 is partially the same as that constituting the high-temperature solder layer 31, a coefficient of thermal expansion (coefficient of thermal expansion, CTE) and an elasticity modulus (modulus) of the material of the high-temperature solder layer 31 are close to those of the material of the low-temperature solder layer 32. In a bonding process, atoms included in both the high-temperature solder layer 31 and the low-temperature solder layer 32 are diffused, so that the high-temperature solder layer 31 is bonded to the low-temperature solder layer 32 through atomic diffusion.

Based on the electronic assembly 100 provided in this embodiment of this application, the high-temperature solder layer 31 is disposed between the low-temperature solder layer 32 and the first solder pad 11, so that the high-temperature solder layer 31 is directly bonded to the first solder pad 11. Because an elongation rate of the high-temperature solder is higher than that of the low-temperature solder, the high-temperature solder is less brittle than the low-temperature solder, and is not easy to break. In view of this, strength of an intermetallic compound (intermetallic compound, IMC) formed when the high-temperature solder layer 31 is bonded to the first solder pad 11 is higher than that of an IMC formed when the low-temperature solder layer 32 is directly bonded to the first solder pad 11 in FIG. 3b, representing an embodiment not forming part of the invention.

In view of this, because the material constituting the low-temperature solder layer 32 is partially the same as that constituting the high-temperature solder layer 31, in the bonding process of the low-temperature solder layer 32 and the high-temperature solder layer 31, the low-temperature solder layer 32 is bonded to the high-temperature solder layer 31 through atomic diffusion. Therefore, no IMC is formed in the bonding process of the low-temperature solder layer 32 and the high-temperature solder layer 31, and stability of the bonding between the low-temperature solder layer 32 and the high-temperature solder layer 31 is high.

When the first electronic component 10 is bonded to the second electronic component 20, in FIG. 3b, the low-temperature solder layer 32 is directly bonded to the first solder pad 11, and an IMC with low strength is formed on a bonding interface. However, in the electronic assembly 100 provided in this embodiment of this application, the high-temperature solder layer 31 is bonded to the first solder pad 11, and an IMC with high strength is formed on a bonding interface. In addition, the low-temperature solder layer 32 is bonded to the high-temperature solder layer 31 through atomic diffusion, and no IMC is formed in a bonding process. Therefore, stability of bonding between the first electronic component 10 and the first soldering portion 30 can be improved, thereby improving stability of the electronic assembly 100.

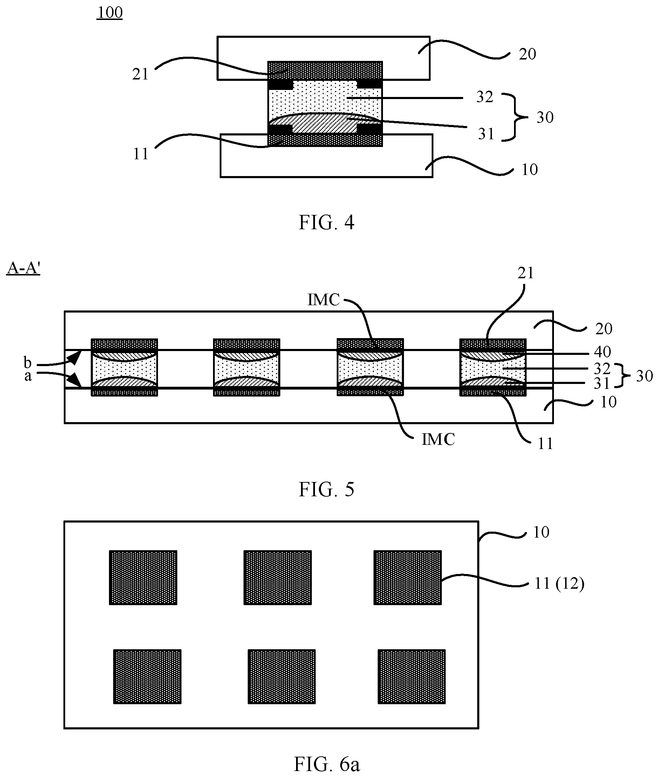

In addition, as shown in FIG. 4, which represents an embodiment not forming part of the invention, it can be learned through stress analysis that, when the electronic assembly 100 is subject to an external force (for example, impact, drop, or vibration), edge locations (indicated by black blocks in FIG. 4) on a contact surface between the first soldering portion 30 and the first solder pad 11 and the second solder pad 21 are subject to a large force. In this embodiment of this application, after the high-temperature solder layer 31 is disposed, the high-temperature solder layer 31 is at a location subject to large stress. Reliability of the high-temperature solder is higher than that of the low-temperature solder. Therefore, compared with directly placing the low-temperature solder layer 32 at a location subject to large stress in FIG. 3b, a structure of the first soldering portion 30 provided in this embodiment of this application can further improve stability of bonding between the first electronic component 10 and the first soldering portion 30.

The following describes in detail a structure of the electronic assembly 100 provided in this embodiment of this application by using several detailed embodiments, which are embodiments of the invention.

### Embodiment 1

An example in which the first electronic component 10 is a PCB and the second electronic component 20 is an LGA device is used for description.

As shown in FIG. 5 (a sectional view along an A-A' direction in FIG. 2a), the electronic assembly 100 includes a first electronic component 10, a second electronic component 20, at least one first soldering portion 30, and at least one second soldering portion 40.

A first active surface a of the first electronic component 10 faces a second active surface b of the second electronic component 20. In addition, an orthographic projection, on the first electronic component 10, of a first solder pad 11 on the first electronic component 10 overlaps an orthographic projection, on the first electronic component 10, of a second solder pad 21 on the second electronic component 20.

The overlapping herein may be that, as shown in FIG. 5, the first solder pad 11 and the second solder pad 21 have a same size and directly face each other. As shown in FIG. 6a, from a perspective of a top view, the orthographic projection of the first solder pad 11 coincides with the orthographic projection of the second solder pad 21.

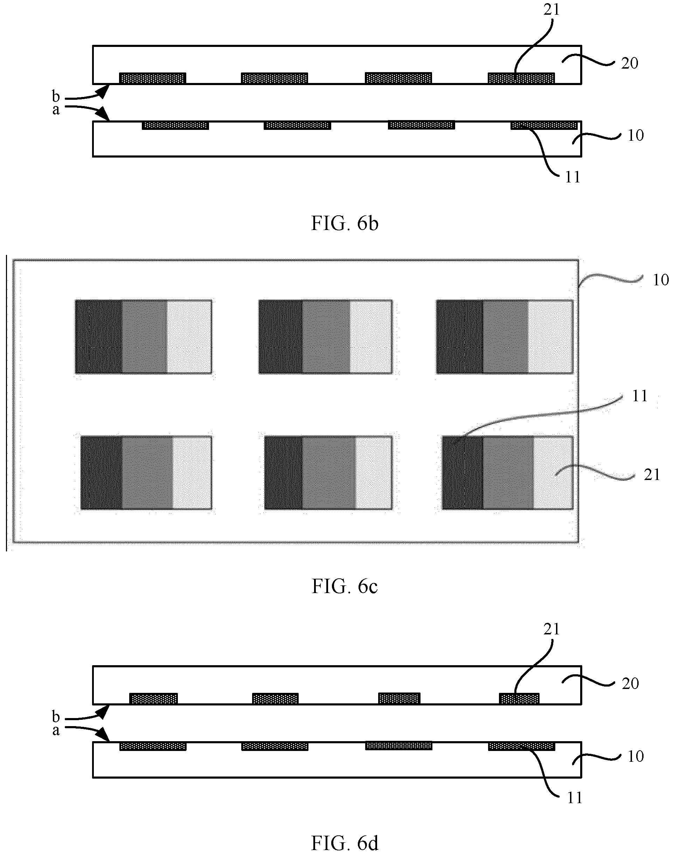

Alternatively, the overlapping herein may be that, as shown in FIG. 6b, the first solder pad 11 and the second solder pad 21 have a same size but are disposed in a staggered manner. As shown in FIG. 6c, from a perspective of a top view, the orthographic projection of the first solder pad 11 intersects with the orthographic projection of the second solder pad 21, and the first solder pad 11 and the second solder pad 21 are in a one-to-one correspondence.

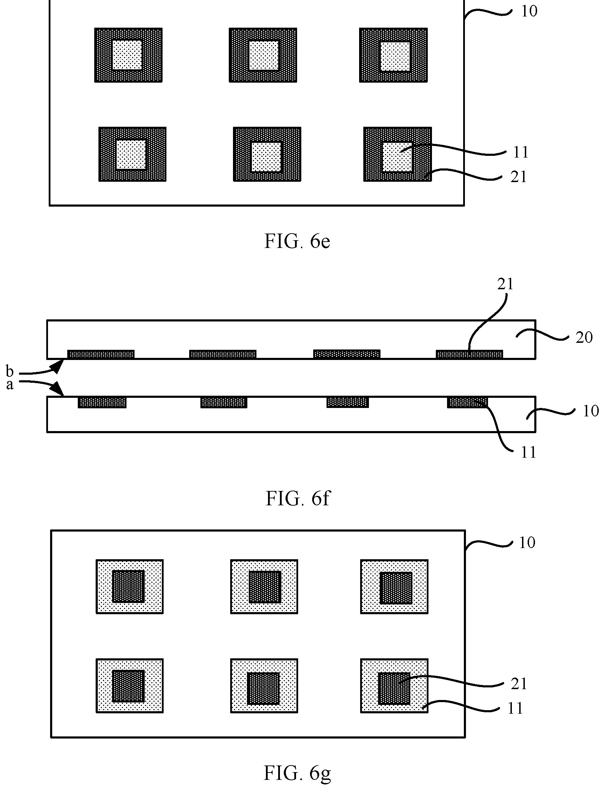

Alternatively, the overlapping herein may be that, as shown in FIG. 6d, a size of the first solder pad 11 is less than that of the second solder pad 21. As shown in FIG. 6e, from a perspective of a top view, the orthographic projection of the first solder pad 11 falls within the orthographic projection of the second solder pad 21.

Alternatively, the overlapping herein may be that, as shown in FIG. 6f, a size of the first solder pad 11 is greater than that of the second solder pad 21. As shown in FIG. 6g, from a perspective of a top view, the orthographic projection of the second solder pad 21 falls within the orthographic projection of the first solder pad 11.

In addition, shapes of the first solder pad 11 and the second solder pad 21 are not limited, and may be closed patterns of any shapes. The shapes of the first solder pad 11 and the second solder pad 21 may be the same or different.

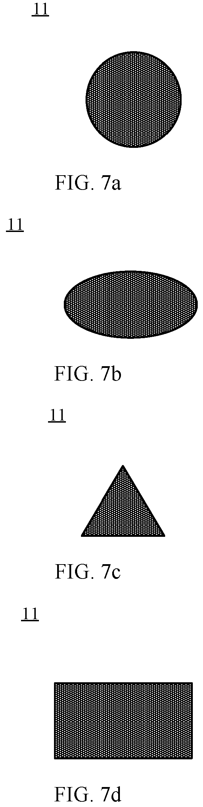

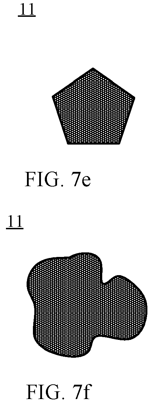

The first solder pad 11 is used as an example. For example, in some possible embodiments, a shape of the first solder pad 11 may be a regular pattern, for example, a circular shape in FIG. 7a, an elliptic shape in FIG. 7b, a triangular shape in FIG. 7c, a rectangular shape in FIG. 7d, a square shape in FIG. 6a, or a pentagonal shape in FIG. 7e. In some other possible embodiments, a shape of the first solder pad 11 may be an irregular pattern in FIG. 7f.

As shown in FIG. 5, a first soldering portion 30 and a second soldering portion 40 are disposed between the first solder pad 11 and the second solder pad 21 that face each other. The first soldering portion 30 is disposed close to the first solder pad 11, and the second soldering portion 40 is disposed close to the second solder pad 21.

The first soldering portion 30 includes a high-temperature solder layer 31 and a low-temperature solder layer 32. The high-temperature solder layer 31 is disposed close to the first solder pad 11, and is bonded to the first solder pad 11. The low-temperature solder layer 32 is disposed close to the second soldering portion 40, and is bonded to the second soldering portion 40. The second soldering portion 40 is further bonded to the second solder pad 21.

A melting point of the low-temperature solder layer 32 is lower than those of the high-temperature solder layer 31 and the second soldering portion 40. A material constituting the low-temperature solder layer is partially the same as that constituting the high-temperature solder layer 31, so that the low-temperature solder layer 32 is bonded to the high-temperature solder layer 31 through atomic diffusion. In addition, the material constituting the low-temperature solder layer is partially the same as that constituting the second soldering portion 40, so that the low-temperature solder layer 32 is bonded to the second soldering portion 40 through atomic diffusion. The material constituting the high-temperature solder layer 31 and the material constituting the second soldering portion 40 may be the same or different.

It can be understood that, based on different materials selected for the high-temperature solder layer 31, processes for preparing the high-temperature solder layer 31 vary, processes for bonding the high-temperature solder layer 31 to the first solder pad 11 also vary, and shapes of a soldering interface between the high-temperature solder layer 31 and the low-temperature solder layer 32 also vary. Similarly, different materials form different second soldering portions 40.

The following describes examples of a bonding process of the first electronic component 10 and the second electronic component 20 based on different materials selected for the high-temperature solder layer 31 and the second soldering portion 40.

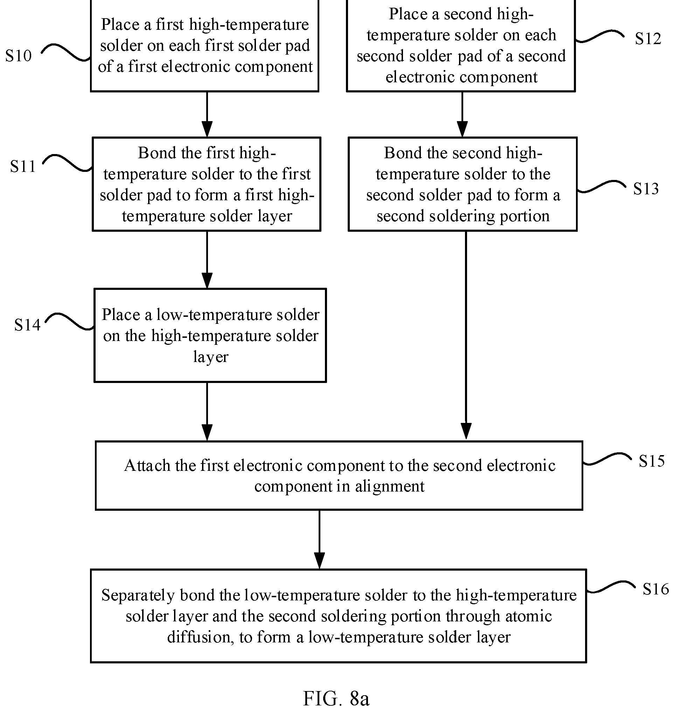

In a possible embodiment, materials of the high-temperature solder layer 31 and the second soldering portion 40 are metal alloys. As shown in FIG. 8a, a bonding process of the first electronic component 10 and the second electronic component 20 is as follows.

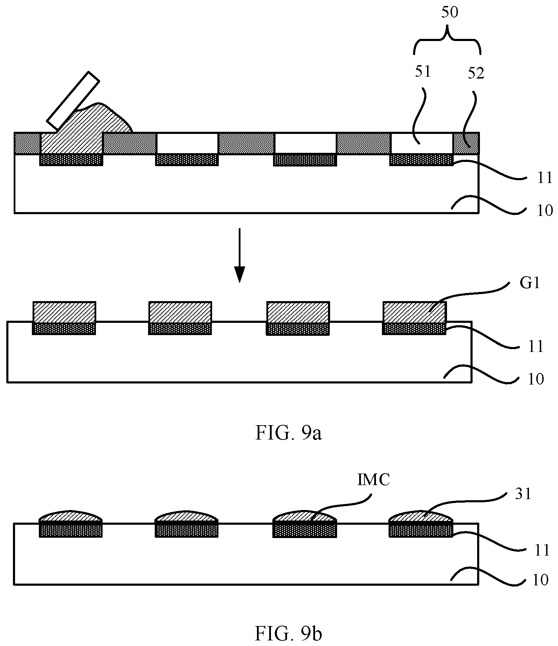

S10: As shown in FIG. 9a, place a first high-temperature solder G1 on each first solder pad 11 of the first electronic component 10.

For example, first, a steel mesh 50 is placed on the first electronic component 10. An opening 51 of the steel mesh 50 corresponds to the first solder pad 11, and a shielding portion 52 of the steel mesh 50 corresponds to a part between adjacent first solder pads 11. Then solder paste is brushed, so that the solder paste is filled in the opening 51 of the steel mesh 50. Then the steel mesh 50 is removed to form the first high-temperature solder G1 on the first solder pad 11.

S11: As shown in FIG. 9b, bond the first high-temperature solder G1 to the first solder pad 11 to form the high-temperature solder layer 31. As shown in FIG. 8a, step S11 is performed after step S10.

For example, the first high-temperature solder G1 is bonded to the first solder pad 11 by using a reflow soldering process based on a temperature corresponding to a reflow temperature curve of the first high-temperature solder G1, to form the first high-temperature solder layer 31 bonded to the first solder pad 11.

When a main material of the first high-temperature solder G1 is different from a material of the first solder pad 11, for example, the main material of the first high-temperature solder G1 is tin and the material of the first solder pad 11 is copper, an IMC is formed on a bonding interface between the first high-temperature solder G1 and the first solder pad 11.

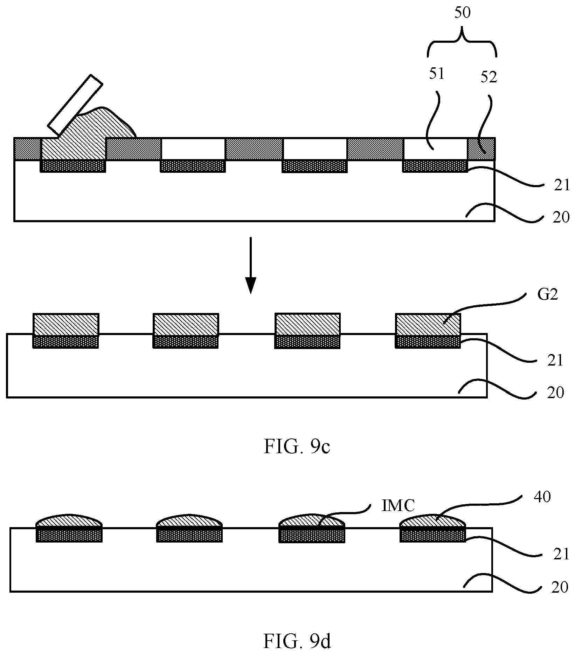

S12: As shown in FIG. 9c, place a second high-temperature solder G2 on each second solder pad 21 of the second electronic component 20.

A method for placing the second high-temperature solder G2 on the second solder pad 21 may be the same as that for placing the first high-temperature solder G1 on the first solder pad 11. Refer to step S10.

S13: As shown in FIG. 9d, bond the second high-temperature solder G2 to the second solder pad 21 to form the second soldering portion 40. As shown in FIG. 8a, step S13 is performed after step S12.

A method for bonding the second high-temperature solder G2 to the second solder pad 21 to form the second soldering portion 40 bonded to the second solder pad 21 may be the same as that for bonding the first high-temperature solder G1 to the first solder pad 11. Refer to step S11.

It should be understood that, there is no sequence between step S10 and step S12, and the two steps may be simultaneously performed in a same time period, or step S12 may be performed after step S10, or step S10 may be performed after step S12.

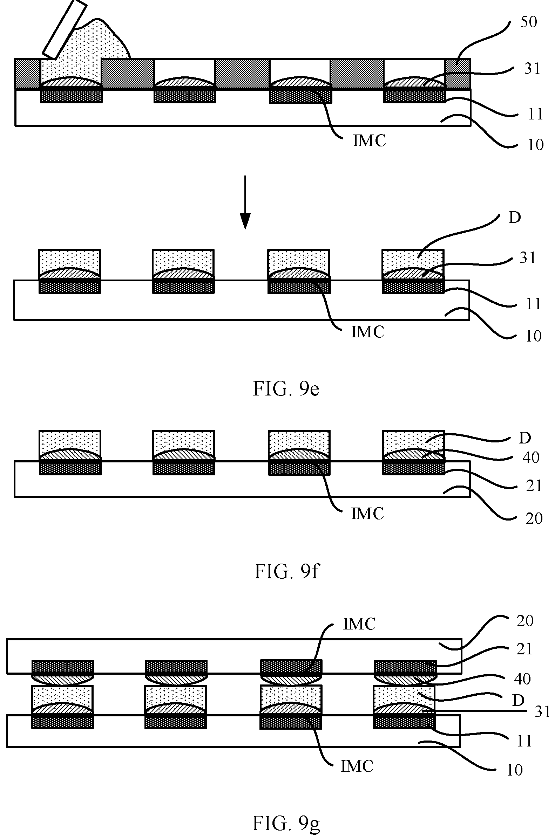

S14: As shown in FIG. 9e, place a low-temperature solder D on the high-temperature solder layer 31. As shown in FIG. 8a, step S14 is performed after step S11.

A method for placing the low-temperature solder D on the high-temperature solder layer 31 may be the same as that for placing the first high-temperature solder G1 on the first solder pad 11 in step S10.

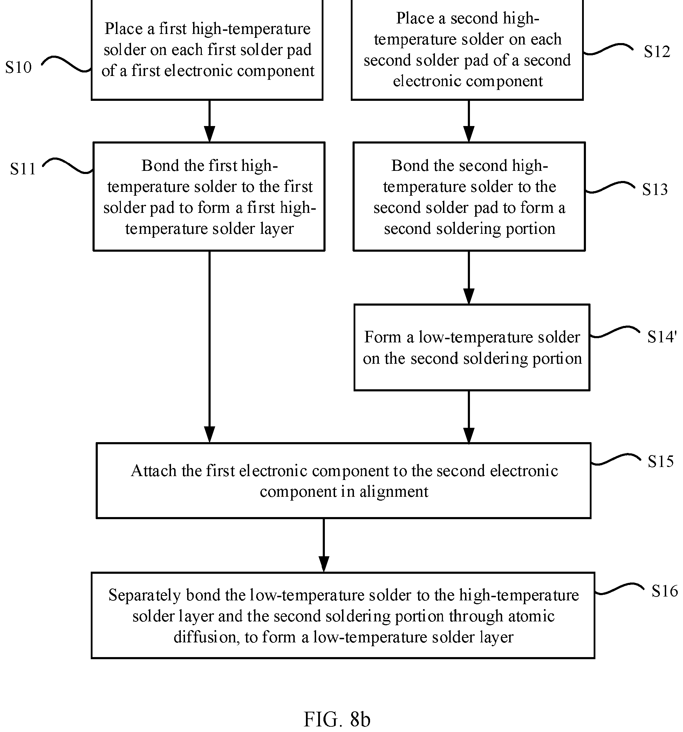

Alternatively, S14' is performed: As shown in FIG. 9f, form a low-temperature solder D on the second soldering portion 40. As shown in FIG. 8b, step S14' is performed after step S13.

S15: As shown in FIG. 9g, attach the first electronic component 10 to the second electronic component 20 in alignment, so that the low-temperature solder D is separately attached to the high-temperature solder layer 31 and the second soldering portion 40.

If the low-temperature solder D is placed on the high-temperature solder layer 31 after step S14 is performed, as shown in FIG. 9g, when the first electronic component 10 is attached to the second electronic component 20 in alignment, the first electronic component 10 is placed with a front side up, and the second electronic component 20 is attached to the front side of the first electronic component 10 in alignment.

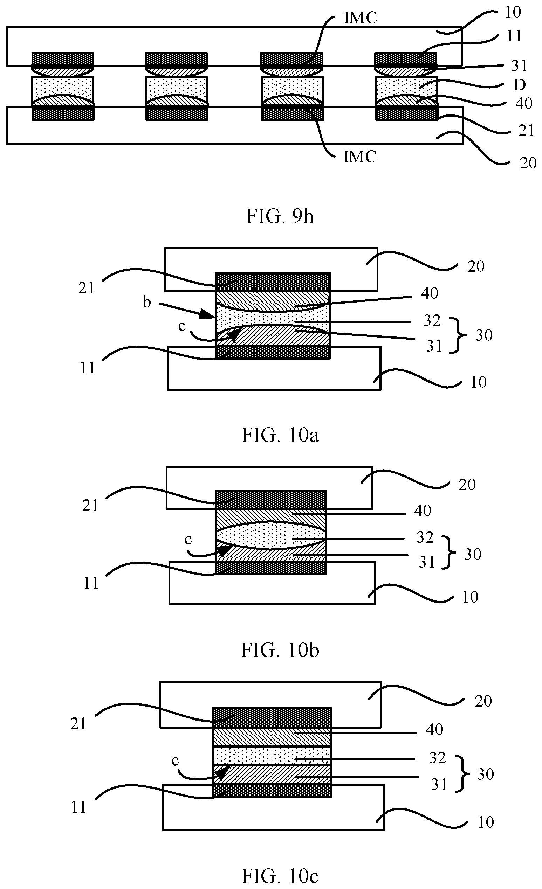

If the low-temperature solder D is placed on the second soldering portion 40 after step S14' is performed, as shown in FIG. 9h, when the first electronic component 10 is attached to the second electronic component 20 in alignment, the second electronic component 20 is placed with a front side up, and the first electronic component 10 is attached to the front side of the second electronic component 20 in alignment.

Herein, regardless of whether step S14 or step S14' is performed, the low-temperature solder D is located between the high-temperature solder layer 31 and the second soldering portion 40 after step S15 is performed.

The low-temperature solder D is placed on the high-temperature solder layer 31 and is not bonded thereto. Therefore, a structure shown in FIG. 9h is used as an example, the second electronic component 20 on which the low-temperature solder D is placed is placed with a front side up as a reference, and the first electronic component 10 on which no low-temperature solder D is placed is attached to the front side of the second electronic component 20 in alignment. This can prevent the low-temperature solder D from detaching from the second soldering portion 40 due to gravity, thereby ensuring reliability of bonding.

S16: As shown in FIG. 5, separately bond the low-temperature solder D to the high-temperature solder layer 31 and the second soldering portion 40 through atomic diffusion, to form the low-temperature solder layer 32.

In this case, the bonded high-temperature solder layer 32 and low-temperature solder layer 31 serve as the first soldering portion 30, and the first soldering portion 30 is bonded to the second soldering portion 40 through atomic diffusion, so that the first electronic component 10 is bonded to the second electronic component 20.

It can be understood that, because a melting point of the low-temperature solder D is lower than those of the high-temperature solder layer 31 and the second soldering portion 40, when the low-temperature solder D is bonded to the high-temperature solder layer 31 and the second soldering portion 40, a heating temperature is lower than a temperature at which the first high-temperature solder G1 is bonded to the first solder pad 11 in step S11. To be specific, when the low-temperature solder D is bonded to the high-temperature solder layer 31 and the second soldering portion 40, the low-temperature solder D is melted, but neither the high-temperature solder layer 31 nor the second soldering portion 40 is melted.

It should be noted: First, in a conventional technology, when the first electronic component 10 is bonded to the second electronic component 20 by using a high-temperature solder, the first electronic component 10 and the second electronic component 20 are deformed to varying extents due to heat in a high-temperature environment. In addition, because the first electronic component 10 is bonded to the second electronic component 20, the first electronic component 10 and the second electronic component 20 are subject to deformation tension from each other, thereby causing warpage and deformation of the first electronic component 10 and the second electronic component 20.

In this embodiment of this application, the first high-temperature solder G1 is bonded to the first solder pad 11 at a high temperature, and the second high-temperature solder G2 is also bonded to the second solder pad 21 at a high temperature. However, the bonding between the first high-temperature solder G1 and the first solder pad 11 is used as an example. When the first high-temperature solder G1 is bonded to the first solder pad 11, bonding is performed on a surface of the first electronic component 10, and the first electronic component 10 is deformed within an acceptable range only due to heat, without being subject to a force from the second electronic component 20. Therefore, a probability of warpage and deformation is significantly reduced.

In addition, the first electronic component 10 is used as an example. When an inactive surface of the first electronic component 10 has a component or a film layer not resistant to a high temperature, the component or the film layer not resistant to a high temperature may be formed after the high-temperature solder layer 31 is formed on the first solder pad 11. For example, when the first electronic component 10 is a fingerprint module that has undergone high-gloss surface processing, because a light film is not resistant to a high temperature, the light film may be formed after the high-temperature solder layer 31 is formed on the first solder pad 11.

Second, due to process factors such as a proportion difference, a reflow curve difference, and a wettability difference between the three solders: the first high-temperature solder G1, the second high-temperature solder G2, and the low-temperature solder D, a shape of a bonding interface between the second soldering portion 40 and the first soldering portion 30, and a shape of a bonding interface between the high-temperature solder layer 31 and the low-temperature solder layer 32 in the first soldering portion 30 may have a plurality of forms. Therefore, shapes of longitudinal cross sections of the first soldering portion 30 and the second soldering portion 40, and the shape of the bonding interface between the first soldering portion 30 and the second soldering portion 40 are not limited in this embodiment of this application.

A principle for forming a shape of a bonding interface between the second soldering portion 40 and the low-temperature solder layer 32 is the same as that for forming the bonding interface between the high-temperature solder layer 31 and the low-temperature solder layer 32 in the first soldering portion 30. The shape of the bonding interface between the high-temperature solder layer 31 and the low-temperature solder layer 32 in the first soldering portion 30 is used as an example for description. It can be understood that, because the high-temperature solder layer 31 is bonded to the low-temperature solder layer 32 through atomic diffusion, the shape of the bonding interface between the high-temperature solder layer 31 and the low-temperature solder layer 32 is a shape of the bonded high-temperature solder layer 31 and first solder pad 11.

In view of this, in a possible implementation, the high-temperature solder layer 31 is bonded to the first solder pad 11 by using a soldering process. In this case, as shown in FIG. 10a, the bonding interface c between the high-temperature solder layer 31 and the low-temperature solder layer 32 is a curved surface whose center is concave toward a side on which the first solder pad 11 is located.

In another possible implementation, the high-temperature solder layer 31 is bonded to the first solder pad 11 by using another process. In this case, as shown in FIG. 10b, the bonding interface c between the high-temperature solder layer 31 and the low-temperature solder layer 32 is a curved surface whose center is convex away from the side on which the first solder pad 11 is located. Alternatively, as shown in FIG. 10c, the bonding interface c between the high-temperature solder layer 31 and the low-temperature solder layer 32 is a plane parallel to the first solder pad 11.

In addition, a shape of a side surface d, of the low-temperature solder layer 32, that intersects with the bonding interface c also has a plurality of forms due to process errors and different placement amounts of the low-temperature solder D. That is, a cross section, of the low-temperature solder layer 32, in a direction perpendicular to the first electronic component 10 (a longitudinal direction) has a plurality of forms. Therefore, the shape of the side surface d of the low-temperature solder layer 32 is not limited in this embodiment of this application.

The following describes examples of the shape of the side surface d, of the low-temperature solder layer 32, that intersects with the bonding interface c.

In a possible implementation, as shown in FIG. 10b, the side surface d of the low-temperature solder layer 32 is a plane.

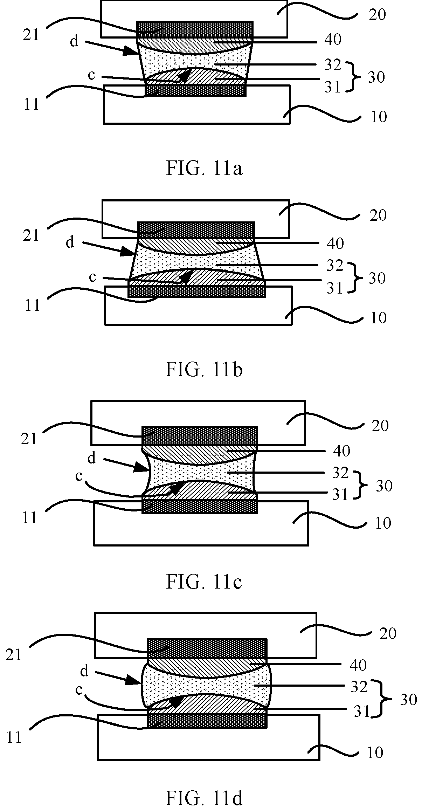

An included angle between the side surface d of the low-temperature solder layer 32 and the first solder pad 11 varies based on different relative sizes of the first solder pad 11 and the second solder pad 21. As shown in FIG. 10b, when the first solder pad 11 and the second solder pad 21 are equal in size, the side surface d of the low-temperature solder layer 32 is a plane perpendicular to the first solder pad 11. As shown in FIG. 11a, when the first solder pad 11 is smaller than the second solder pad 21, the side surface d of the low-temperature solder layer 32 is a plane that has an included angle of greater than 90° with the first solder pad 11. As shown in FIG. 11b, when the first solder pad 11 is larger than the second solder pad 21, the side surface d of the low-temperature solder layer 32 is a plane that has an included angle of less than 90° with the first solder pad 11. In another possible implementation, if a placement amount of the low-temperature solder D is small, as shown in FIG. 11c, the side surface d of the low-temperature solder layer 32 is a curved surface that is concave inward.

In another possible implementation, if a placement amount of the low-temperature solder D is large, as shown in FIG. 11d, the side surface d of the low-temperature solder layer 32 is a curved surface that is convex outward.

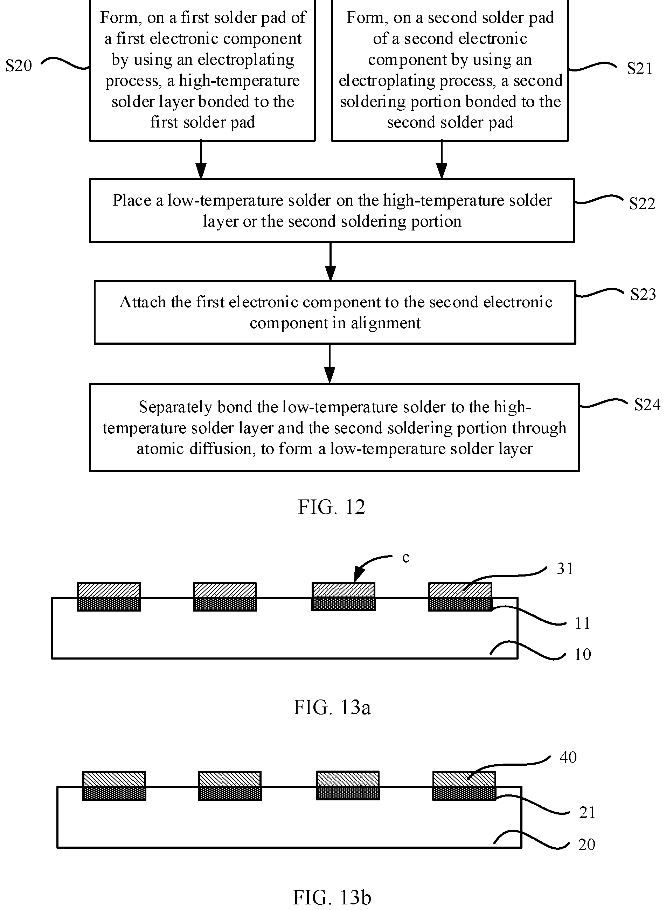

In another possible embodiment, the material of the high-temperature solder layer 31 is a pure metal. As shown in FIG. 12, a bonding process of the first electronic component 10 and the second electronic component 20 is as follows.

S20: As shown in FIG. 13a, form, on the first solder pad 11 of the first electronic component 10 by using an electroplating process, the high-temperature solder layer 31 bonded to the first solder pad 11.

A surface, of the high-temperature solder layer 31 formed by using the electroplating process, that is away from the first solder pad 11 (a bonding interface c between the high-temperature solder layer 31 and the low-temperature solder layer 32) is a plane parallel to the first solder pad 11. S21: As shown in FIG. 13b, form, on the second solder pad 21 of the second electronic component 20 by using an electroplating process, the second soldering portion 40 bonded to the second solder pad 21.

Similarly, a surface, of the second soldering portion 40 formed by using the plating process, that is away from the second solder pad 21 is a plane parallel to the second solder pad 21.

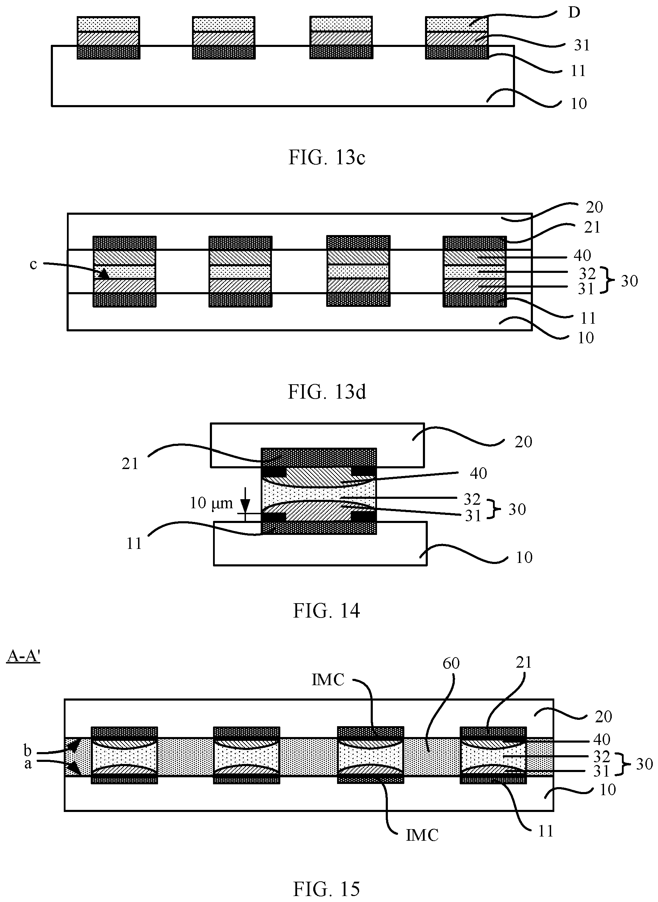

S22: Place a low-temperature solder D on the high-temperature solder layer 31 or the second soldering portion 40. In FIG. 13c, an example in which the low-temperature solder D is placed on the high-temperature solder layer 31 is used for description.

A method for placing the low-temperature solder D on the high-temperature solder layer 31 or the second soldering portion 40 may be the same as that for placing the first high-temperature solder G1 on the first solder pad 11 in step S10.

S23: Attach the first electronic component 10 to the second electronic component 20 in alignment. S24: As shown in FIG. 13d, separately bond the low-temperature solder D to the high-temperature solder layer 31 and the second soldering portion 40 through atomic diffusion, to form the low-temperature solder layer 32. The bonded high-temperature solder layer 31 and low-temperature solder layer 32 serve as the first soldering portion 30, and the first soldering portion 30 is bonded to the second soldering portion 40 through atomic diffusion, so that the first electronic component 10 is bonded to the second electronic component 20.

In this case, as shown in FIG. 13d, after the first electronic component 10 is bonded to the second electronic component 20, the bonding interface c between the high-temperature solder layer 31 and the low-temperature solder layer 32 is a plane parallel to the first solder pad 11. A bonding interface between the second soldering portion 40 and the low-temperature solder layer 32 is also a plane parallel to the first solder pad 11.

For a shape of a side surface d of the low-temperature solder layer 32, refer to the foregoing descriptions of FIG. 11a to FIG. 11d.

Based on the foregoing structure, as shown in FIG. 14, when the electronic assembly is subject to an external force (for example, impact, drop, or vibration), edge locations on a contact surface between the first soldering portion 30 and the first solder pad 11 and edge locations (indicated by black blocks in FIG. 14) on a contact surface between the second soldering portion 40 and the second solder pad 21 are subject to a large force and are a stress concentration region, and a middle region is a low-stress region. Brittleness of the high-temperature solder is lower than that of the low-temperature solder, that is, reliability of the high-temperature solder is higher than that of the low-temperature solder. Therefore, in this embodiment of this application, a thickness of the high-temperature solder layer 31 is adjusted, so that the high-temperature solder layer 31 is located in the stress concentration region, and the low-temperature solder layer 32 is not disposed in the stress concentration region, to improve stability of bonding between the first electronic component 10 and the second electronic component 20.

With drop simulation analysis on the electronic assembly 100, the first soldering portion 30 and the second soldering portion 40 are subject to large stress at a location within 10 µm away from the first solder pad 11 and the second solder pad 21. However, when the first soldering portion 30 and the second soldering portion 40 are excessively thick, this is not conducive to preparation by brushing solder paste over a steel mesh. In view of this, in some embodiments of this application, thicknesses of the high-temperature solder layer 31 and the second soldering portion 40 are 10-100 µm. For example, the thicknesses of the high-temperature solder layer 31 and the second soldering portion 40 are 20 µm, 30 µm, 40 µm, 50 µm, 60 µm, 70 µm, 80 µm, or 90 µm. In this embodiment of this application, a thickness of a component is a size of the component in a direction perpendicular to the first solder pad.

In addition, when the low-temperature solder layer 32 is excessively thin, a bonding effect between the low-temperature solder layer 32 and each of the high-temperature solder layer 31 and the second soldering portion 40 is affected. However, when the low-temperature solder layer 32 is excessively thick, this is not conducive to preparation by brushing solder paste over a steel mesh. In view of this, in some embodiments of this application, a thickness of the low-temperature solder layer 32 is 50-100 µm. For example, the thickness of the low-temperature solder layer 32 is 60 µm, 70 µm, 80 µm, or 90 µm.

It can be learned from drop simulation analysis on the electronic assembly 100 that a force applied to the first soldering portion 30 and the second soldering portion 40 in the stress concentration region shown in FIG. 14 is approximately 40% greater than a force applied in the low-stress region. That is, with the structure provided in this embodiment of this application, stress applied to the low-temperature solder layer 32 can be reduced by approximately 40%. Therefore, stability of bonding between the first electronic component 10 and the second electronic component 20 can be ensured, to extend a service life of the electronic device 1.

Based on the electronic assembly shown in FIG. 5, as shown in FIG. 15 (a sectional view along an A-A' direction in FIG. 2a), the electronic assembly further includes an underfill (underfill) adhesive layer 60 located between the first electronic component 10 and the second electronic component 20. The underfill adhesive layer 60 is separately bonded to the first active surface a of the first electronic component 10 and the second active surface b of the second electronic component 20. In addition, the underfill adhesive layer 60 surrounds peripheries of the first soldering portion 30 and the second soldering portion 40, and is bonded to the first soldering portion 30 and the second soldering portion 40.

A material of the underfill adhesive layer 60 may be a thermal cured adhesive.

In addition, the underfill adhesive layer 60 is filled between the first electronic component 10 and the second electronic component 20, and the underfill adhesive layer 60 is bonded to the first soldering portion 30 and the second soldering portion 40, so that the first soldering portion 30 and the second soldering portion 40 can be protected and secured, to further improve stability of bonding between the first electronic component 10 and the second electronic component 20.

In addition, in this embodiment, the first soldering portion 30 and the second soldering portion 40 include three solder layers, and the three solder layers are not too thin, so that a gap between the first electronic component 10 and the second electronic component 20 is large. In this way, when the underfill adhesive layer 60 is formed, an adhesive is subject to small resistance, and the adhesive has good fluidity. This can ensure that the adhesive fully cover each solder joint including a first soldering portion 30 and a second soldering portion 40, thereby further improving stability of bonding between the first electronic component 10 and the second electronic component 20.

### Embodiment 2

A difference between Embodiment 2 and Embodiment 1 lies in that the first electronic component 10 is a PCB and the second electronic component 20 is a BGA device.

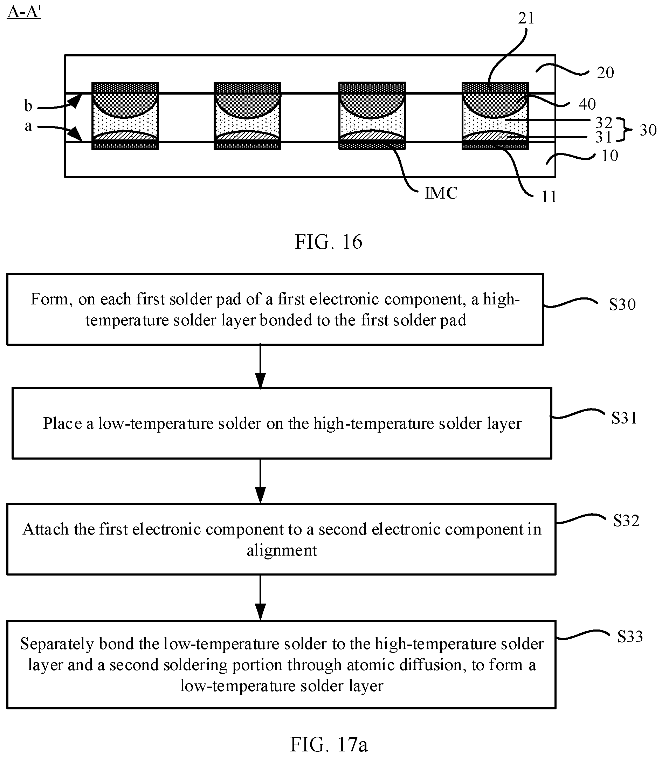

As shown in FIG. 16 (a sectional view along an A-A' direction in FIG. 2a), the second soldering portion 40 is a micro protrusion disposed on the second solder pad 21. In this case, the second soldering portion 40 is a component in the second electronic component 20, and no step of forming the second soldering portion 40 is performed when the first electronic component 10 is bonded to the second electronic component 20.

The micro protrusion may be a solder ball (ball), or may be a bump (bump) or the like. In this embodiment of this application, an example in which the second soldering portion 40 is a solder ball is used for description.

In view of this, as shown in FIG. 17a, a bonding process of the first electronic component 10 and the second electronic component 20 is as follows.

S30: Form, on each first solder pad 11 of the first electronic component 10, a high-temperature solder layer 31 bonded to the first solder pad 11.

In an example, step S30 may include: as shown in FIG. 9a, placing a first high-temperature solder G1 on each first solder pad 11 of the first electronic component 10; and as shown in FIG. 9b, bonding the first high-temperature solder G1 to the first solder pad 11 to form the high-temperature solder layer 31.

In another example, step S30 may include: as shown in FIG. 13a, forming, on the first solder pad 11 of the first electronic component 10 by using an electroplating process, the high-temperature solder layer 31 bonded to the first solder pad 11.

S31: As shown in FIG. 9e and FIG. 13c, place a low-temperature solder D on the high-temperature solder layer 31.

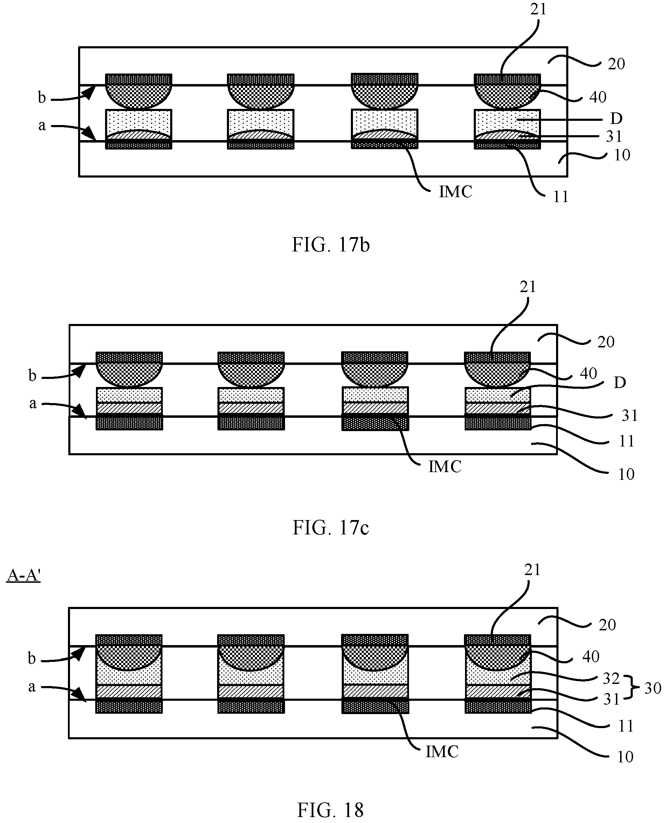

S32: As shown in FIG. 17b and FIG. 17c, attach the first electronic component 10 to the second electronic component 20 in alignment.

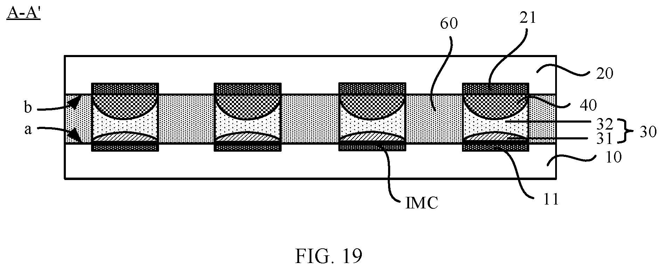

S33: As shown in FIG. 16 and FIG. 18 (sectional views along an A-A' direction in FIG. 2a), separately bond the low-temperature solder D to the high-temperature solder layer 31 and the second soldering portion 40 through atomic diffusion, to form the low-temperature solder layer 32, so that the first electronic component 10 is bonded to the second electronic component 20. Based on the structure of the electronic assembly shown in FIG. 16, as shown in FIG. 19 (a sectional view along an A-A' direction in FIG. 2a), the electronic assembly further includes an underfill adhesive layer 60 located between the first electronic component 10 and the second electronic component 20. The underfill adhesive layer 60 is separately bonded to the first active surface a of the first electronic component 10 and the second active surface b of the second electronic component 20, surrounds peripheries of the first soldering portion 30 and the second soldering portion 40, and is bonded to the first soldering portion 30 and the second soldering portion 40.

The foregoing descriptions are merely specific implementations of this application, but are not intended to limit the protection scope of this application. The invention is defined by the appended claims.

## Claims

1. An electronic assembly (100), comprising:
a first electronic component (10), wherein a first active surface (a) of the first electronic component (10) has at least one first solder pad (11);
a second electronic component (20), wherein a second active surface (b) of the second electronic component (20) has at least one second solder pad (21), and the second active surface faces the first active surface; and
at least one first soldering portion (30), wherein one first soldering portion (30) is located between one first solder pad (11) and one second solder pad (21), and the first soldering portion (30) is bonded to the first solder pad (11) and the second solder pad (21) on both sides of the first soldering portion (30), wherein
the first soldering portion (30) comprises a high-temperature solder layer (31) and a low-temperature solder layer (32), the high-temperature solder layer (31) is disposed close to the first solder pad (11) and is bonded to the first solder pad (11), and the low-temperature solder layer (32) is disposed close to the second solder pad (21) and is bonded to the second solder pad (21); and
the electronic assembly (100) further comprising:
at least one second soldering portion (40), wherein the second soldering portion (40) is disposed on a side of the first soldering portion (30) close to the second solder pad (21), and is bonded to the second solder pad (21); and
a melting point of the low-temperature solder layer (32) is lower than that of the high-temperature solder layer (31) and than that of the second soldering portion (40), and a material constituting the low-temperature solder layer (32) is partially the same as that constituting the high-temperature solder layer (31) and the second soldering portion (40), so that the low-temperature solder layer (32) is bonded to the high-temperature solder layer (31) and the second soldering portion (40) through atomic diffusion,
**characterised in that**
the high-temperature solder layer (31) or the second soldering portion (40) has a thickness of 10-100 µm in a direction perpendicular to the first solder pad (11).

2. The electronic assembly (100) according to claim 1, wherein a bonding interface between the high-temperature solder layer (31) and the low-temperature solder layer (32) is a plane, and the material constituting the high-temperature solder layer (31) is a pure metal.

3. The electronic assembly (100) according to claim 1, wherein a bonding interface between the high-temperature solder layer (31) and the low-temperature solder layer (32) is a curved surface whose center is concave toward a side on which the first solder pad (11) is located, and the material constituting the high-temperature solder layer (31) is a metal alloy.

4. The electronic assembly (100) according to claim 1, wherein an orthographic projection of the first solder pad (11) on the first electronic component (10) falls within an orthographic projection of the second solder pad (21) on the first electronic component (20).

5. The electronic assembly (100) according to claim 1, wherein the low-temperature solder layer (32) has a thickness of 50-100 µm in a direction perpendicular to the first solder pad (11).

6. The electronic assembly (100) according to claim 1, wherein the second soldering portion (40) is a micro protrusion disposed on the second solder pad (21).

7. The electronic assembly (100) according to claim 1, wherein the electronic assembly (100) further comprises an underfill adhesive layer (60) located between the first electronic component (10) and the second electronic component (20); and
the underfill adhesive layer (60) is separately bonded to the first active surface (a) and the second active surface (b), surrounds peripheries of the first soldering portion (30) and the second soldering portion (40), and is bonded to the first soldering portion (30) and the second soldering portion (40).

8. A method for preparing an electronic assembly (100), wherein the electronic assembly (100) comprises a first electronic component (10) and a second electronic component (20), a first active surface (a) of the first electronic component (10) has at least one first solder pad (11), a second active surface (b) of the second electronic component (20) has at least one second solder pad (21), and the second active surface (b) faces the first active surface (a); and
the method for preparing an electronic assembly (100) comprises:
forming (S11, S20, S30), on each first solder pad (11) of the first electronic component (10), a high-temperature solder layer (31) bonded to the first solder pad (11);
forming (S13, S21), on each second solder pad (21) of the second electronic component (20), a second soldering portion (40) bonded to the second solder pad (21),
placing (S14, S22, S31) a low-temperature solder (D) between the high-temperature solder layer (31) and the second solder pad (21); and
separately bonding (S16, S24, S33) the low-temperature solder (D) to the high-temperature solder layer (31) and to the second soldering portion (40) on the second solder pad (21) through atomic diffusion, to form a low-temperature solder layer (32), wherein the bonded high-temperature solder layer (31) and low-temperature solder layer (32) serve as a first soldering portion (30) to bond the first electronic component (10) to the second electronic component (20), and wherein
a melting point of the low-temperature solder layer (32) is lower than that of the high-temperature solder layer (31) and than that of the second soldering portion (40), and a material constituting the low-temperature solder layer (32) is partially the same as that constituting the high-temperature solder layer (31) and as that constituting the second soldering portion (40),
**characterised in that**
the high-temperature solder layer (31) or the second soldering portion (40) has a thickness of 10-100 µm in a direction perpendicular to the first solder pad (11).

9. An electronic device (1), comprising the electronic assembly (100) according to any one of claims 1 to 7.

## Patentansprüche

1. Elektronische Baugruppe (100), umfassend:
eine erste elektronische Komponente (10), wobei eine erste aktive Oberfläche (a) der ersten elektronischen Komponente (10) mindestens ein erstes Lötpad (11) aufweist;
eine zweite elektronische Komponente (20), wobei eine zweite aktive Oberfläche (b) der zweiten elektronischen Komponente (20) mindestens ein zweites Lötpad (21) aufweist und die zweite aktive Oberfläche der ersten aktiven Oberfläche zugewandt ist; und
mindestens einen ersten Lötabschnitt (30), wobei sich ein erster Lötabschnitt (30) zwischen einem ersten Lötpad (11) und einem zweiten Lötpad (21) befindet und der erste Lötabschnitt (30) auf beiden Seiten des ersten Lötabschnitts (30) an dem ersten Lötpad (11) und dem zweiten Lötpad (21) gebunden ist, wobei
der erste Lötabschnitt (30) eine Hochtemperaturlötschicht (31) und eine Niedertemperaturlötschicht (32) umfasst, wobei die Hochtemperaturlötschicht (31) nahe dem ersten Lötpad (11) angeordnet ist und an dem ersten Lötpad (11) gebunden ist und die Niedertemperaturlötschicht (32) nahe dem zweiten Lötpad (21) angeordnet ist und an dem zweiten Lötpad (21) gebunden ist; und
die elektronische Baugruppe (100) ferner Folgendes umfasst:
mindestens einen zweiten Lötabschnitt (40), wobei der zweite Lötabschnitt (40) auf einer Seite des ersten Lötabschnitts (30) nahe dem zweiten Lötpad (21) angeordnet ist und an dem zweiten Lötpad (21) gebunden ist; und
ein Schmelzpunkt der Niedertemperaturlötschicht (32) niedriger als jener der Hochtemperaturlötschicht (31) und als jener des zweiten Lötabschnitts (40) ist und ein Material, aus dem die Niedertemperaturlötschicht (32) besteht, teilweise das gleiche wie jenes, aus dem die Hochtemperaturlötschicht (31) und der zweite Lötabschnitt (40) bestehen, ist, sodass die Niedertemperaturlötschicht (32) durch atomare Diffusion an der Hochtemperaturlötschicht (31) und dem zweiten Lötabschnitt (40) gebunden ist, **dadurch gekennzeichnet, dass**
die Hochtemperaturlötschicht (31) oder der zweite Lötabschnitt (40) eine Dicke von 10-100 µm in einer senkrechten Richtung zu dem ersten Lötpad (11) aufweist.

2. Elektronische Baugruppe (100) nach Anspruch 1, wobei eine Bindeschnittstelle zwischen der Hochtemperaturlötschicht (31) und der Niedertemperaturlötschicht (32) eine Ebene ist und das Material, aus dem die Hochtemperaturlötschicht (31) besteht, ein reines Metall ist.

3. Elektronische Baugruppe (100) nach Anspruch 1, wobei eine Bindeschnittstelle zwischen der Hochtemperaturlötschicht (31) und der Niedertemperaturlötschicht (32) eine gekrümmte Oberfläche ist, deren Mitte zu einer Seite hin, auf der sich das erste Lötpad (11) befindet, konkav ist und das Material, aus dem die Hochtemperaturlötschicht (31) besteht, eine Metalllegierung ist.

4. Elektronische Baugruppe (100) nach Anspruch 1, wobei eine orthographische Projektion des ersten Lötpads (11) auf der ersten elektronischen Komponente (10) in eine orthographische Projektion des zweiten Lötpads (21) auf der ersten elektronischen Komponente (20) fällt.

5. Elektronische Baugruppe (100) nach Anspruch 1, wobei die Niedertemperaturlötschicht (32) eine Dicke von 50-100 µm in einer senkrechten Richtung zu dem ersten Lötpad (11) aufweist.

6. Elektronische Baugruppe (100) nach Anspruch 1, wobei der zweite Lötabschnitt (40) ein Mikrovorsprung ist, der auf dem zweiten Lötpad (21) angeordnet ist.

7. Elektronische Baugruppe (100) nach Anspruch 1, wobei die elektronische Baugruppe (100) ferner eine Unterfüllklebstoffschicht (60) umfasst, die sich zwischen der ersten elektronischen Komponente (10) und der zweiten elektronischen Komponente (20) befindet; und
die Unterfüllklebstoffschicht (60) separat an der ersten aktiven Oberfläche (a) und der zweiten aktiven Oberfläche (b) gebunden ist, Umfänge des ersten Lötabschnitts (30) und des zweiten Lötabschnitts (40) umgibt und an dem ersten Lötabschnitt (30) und dem zweiten Lötabschnitt (40) gebunden ist.

8. Verfahren zum Vorbereiten einer elektronischen Baugruppe (100), wobei die elektronische Baugruppe (100) eine erste elektronische Komponente (10) und eine zweite elektronische Komponente (20) umfasst, eine erste aktive Oberfläche (a) der ersten elektronischen Komponente (10) mindestens ein erstes Lötpad (11) aufweist, eine zweite aktive Oberfläche (b) der zweiten elektronischen Komponente (20) mindestens ein zweites Lötpad (21) aufweist und die zweite aktive Oberfläche (b) der ersten aktiven Oberfläche (a) zugewandt ist; und
das Verfahren zum Vorbereiten einer elektronischen Baugruppe (100) Folgendes umfasst:
Bilden (S11, S20, S30), auf jedem ersten Lötpad (11) der ersten elektronischen Komponente (10), einer Hochtemperaturlötschicht (31), die an dem ersten Lötpad (11) gebunden ist;
Bilden (S13, S21), auf jedem zweiten Lötpad (21) der zweiten elektronischen Komponente (20), eines zweiten Lötabschnitts (40), der an dem zweiten Lötpad (21) gebunden ist,
Platzieren (S14, S22, S31) einer Niedertemperaturlötung (D) zwischen der Hochtemperaturlötschicht (31) und dem zweiten Lötpad (21); und
separates Binden (S16, S24, S33) der Niedertemperaturlötung (D) an der Hochtemperaturlötschicht (31) und an dem zweiten Lötabschnitt (40) auf dem zweiten Lötpad (21) durch atomare Diffusion, um eine Niedertemperaturlötschicht (32) zu bilden, wobei die gebundene Hochtemperaturlötschicht (31) und Niedertemperaturlötschicht (32) als ein erster Lötabschnitt (30) dienen, um die erste elektronische Komponente (10) an der zweiten elektronischen Komponente (20) zu binden, und wobei
ein Schmelzpunkt der Niedertemperaturlötschicht (32) niedriger als jener der Hochtemperaturlötschicht (31) und als jener des zweiten Lötabschnitts (40) ist und ein Material, aus dem die Niedertemperaturlötschicht (32) besteht, teilweise das gleiche wie jenes, aus dem die Hochtemperaturlötschicht (31) besteht, und wie jenes, aus dem der zweite Lötabschnitt (40) besteht, ist, **dadurch gekennzeichnet, dass**
die Hochtemperaturlötschicht (31) oder der zweite Lötabschnitt (40) eine Dicke von 10-100 µm in einer senkrechten Richtung zu dem ersten Lötpad (11) aufweist.

9. Elektronisches Gerät (1), umfassend die elektronische Baugruppe (100) nach einem der Ansprüche 1 bis 7.

## Revendications

1. Ensemble électronique (100), comprenant :
un premier composant électronique (10), dans lequel une première surface active (a) du premier composant électronique (10) a au moins un premier plot de soudure (11) ;
un second composant électronique (20), dans lequel une seconde surface active (b) du second composant électronique (20) a au moins un second plot de soudure (21), et la seconde surface active fait face à la première surface active ; et
au moins une première partie de soudure (30), dans lequel une première partie de soudure (30) est située entre un premier plot de soudure (11) et un second plot de soudure (21), et la première partie de soudure (30) est liée au premier plot de soudure (11) et au second plot de soudure (21) des deux côtés de la première partie de soudure (30), dans lequel
la première partie de soudure (30) comprend une couche de soudure à haute température (31) et une couche de soudure à basse température (32), la couche de soudure à haute température (31) est disposée à proximité du premier plot de soudure (11) et est liée au premier plot de soudure (11), et la couche de soudure à basse température (32) est disposée à proximité du second plot de soudure (21) et est liée au second plot de soudure (21) ; et
l'ensemble électronique (100) comprenant également :
au moins une seconde partie de soudure (40), dans lequel la seconde partie de soudure (40) est disposée sur un côté de la première partie de soudure (30) à proximité du second plot de soudure (21), et est liée au second plot de soudure (21) ; et
un point de fusion de la couche de soudure à basse température (32) est inférieur à celui de la couche de soudure à haute température (31) et à celui de la seconde partie de soudure (40), et un matériau constituant la couche de soudure à basse température (32) est partiellement le même que celui constituant la couche de soudure à haute température (31) et la seconde partie de soudure (40), de sorte que la couche de soudure à basse température (32) est liée à la couche de soudure à haute température (31) et à la seconde partie de soudure (40) par diffusion atomique, **caractérisé en ce que**
la couche de soudure à haute température (31) ou la seconde partie de soudure (40) a une épaisseur de 10 à 100 µm dans une direction perpendiculaire au premier plot de soudure (11).

2. Ensemble électronique (100) selon la revendication 1, dans lequel une interface de liaison entre la couche de soudure à haute température (31) et la couche de soudure à basse température (32) est un plan, et le matériau constituant la couche de soudure à haute température (31) est un métal pur.

3. Ensemble électronique (100) selon la revendication 1, dans lequel une interface de liaison entre la couche de soudure à haute température (31) et la couche de soudure à basse température (32) est une surface courbe dont le centre est concave vers un côté sur lequel se trouve le premier plot de soudure (11), et le matériau constituant la couche de soudure à haute température (31) est un alliage métallique.

4. Ensemble électronique (100) selon la revendication 1, dans lequel une projection orthographique du premier plot de soudure (11) sur le premier composant électronique (10) tombe dans une projection orthographique du second plot de soudure (21) sur le premier composant électronique (20).

5. Ensemble électronique (100) selon la revendication 1, dans lequel la couche de soudure à basse température (32) a une épaisseur de 50 à 100 µm dans une direction perpendiculaire au premier plot de soudure (11).

6. Ensemble électronique (100) selon la revendication 1, dans lequel la seconde partie de soudure (40) est une micro-saillie disposée sur le second plot de soudure (21).

7. Ensemble électronique (100) selon la revendication 1, dans lequel l'ensemble électronique (100) comprend également une couche adhésive de sous-remplissage (60) située entre le premier composant électronique (10) et le second composant électronique (20) ; et
la couche adhésive de sous-remplissage (60) est liée séparément à la première surface active (a) et à la seconde surface active (b), entoure les périphéries de la première partie de soudure (30) et de la seconde partie de soudure (40), et est liée à la première partie de soudure (30) et à la seconde partie de soudure (40).

8. Procédé de préparation d'un ensemble électronique (100), dans lequel l'ensemble électronique (100) comprend un premier composant électronique (10) et un second composant électronique (20), une première surface active (a) du premier composant électronique (10) a au moins un premier plot de soudure (11), une seconde surface active (b) du second composant électronique (20) a au moins un second plot de soudure (21), et la seconde surface active (b) fait face à la première surface active (a) ; et
le procédé de préparation d'un ensemble électronique (100) comprend :
la formation (S11, S20, S30), sur chaque premier plot de soudure (11) du premier composant électronique (10), d'une couche de soudure à haute température (31) liée au premier plot de soudure (11) ;
la formation (S13, S21), sur chaque second plot de soudure (21) du second composant électronique (20), d'une seconde partie de soudure (40) liée au second plot de soudure (21),
le placement (S14, S22, S31) d'une soudure à basse température (D) entre la couche de soudure à haute température (31) et le second plot de soudure (21) ; et
la liaison séparée (S16, S24, S33) de la soudure à basse température (D) à la couche de soudure à haute température (31) et à la seconde partie de soudure (40) sur le second plot de soudure (21) par diffusion atomique, pour former une couche de soudure à basse température (32), dans lequel la couche de soudure à haute température (31) et la couche de soudure à basse température (32) liées servent de première partie de soudure (30) pour lier le premier composant électronique (10) au second composant électronique (20), et dans lequel
un point de fusion de la couche de soudure à basse température (32) est inférieur à celui de la couche de soudure à haute température (31) et à celui de la seconde partie de soudure (40), et un matériau constituant la couche de soudure à basse température (32) est partiellement le même que celui constituant la couche de soudure à haute température (31) et que celui constituant la seconde partie de soudure (40), **caractérisé en ce que**
la couche de soudure à haute température (31) ou la seconde partie de soudure (40) a une épaisseur de 10 à 100 µm dans une direction perpendiculaire au premier plot de soudure (11).

9. Dispositif électronique (1), comprenant l'ensemble électronique (100) selon l'une quelconque des revendications 1 à 7.
